# EUROPEAN PATENT APPLICATION

(11) **EP 4 529 011 A1**
(43) Date of publication of application: **26.03.2025**
(21) Application number: 24188275.2
(22) Date of filing: 12.07.2024
(51) Int. Cl.: H02M 3/158, H02M 3/07, H02M 1/00, H02M 3/00, G06F 1/26, H01L 23/498

(54) **INPUT-SIDE PACKAGE INDUCTOR-BASED VOLTAGE CONVERTER**

(30) Priority: 25.09.2023 US 202318474144
(71) Applicant: Intel Corporation, Santa Clara, CA 95054 (US)
(72) Inventor: DESAI, Nachiket, Portland, 97229 (US); AHMED, Khondker, Hillsboro, 97124 (US); BUTZEN, Nicolas, Portland, 97229 (US); DOUGLAS, Jonathan, Cave Creek, 85331 (US); KIM, Suhwan, Portland, 97225 (US); KRISHNAMURTHY, Harish, Beaverton, 97006 (US); PHAM, Hieu, San Diego, 92092 (US); RADHAKRISHNAN, Kaladhar, Chandler, 85226 (US); RAVICHANDRAN, Krishnan, Saratoga, 95070 (US)
(74) Representative: Viering, Jentschura & Partner mbB Patent- und Rechtsanwälte

(57) **Abstract**

Embodiments herein relate to a voltage regular (VR) formed from a first die stacked on a package base layer. The VR can have an inductor-first design in which an inductor is in the package base layer and active circuitry such as switches is in the first die. The inductor receives an input voltage, Vin, directly from the package base layer without the input voltage first entering the first die. The VR can comprise a Kappa VR which includes first and second inductors in the package base layer. The inductors can have asymmetric inductances to improve efficiency. The VR can be cascaded with a set of current multipliers or a Continuously Scalable Conversion Ratio (CSCR) capacitive regulator. Another example implementation includes a switched-inductor-capacitor converter cascaded with a set of switched capacitor current multipliers.

## Description

### FIELD

The present application generally relates to the field of voltage converters.

### BACKGROUND

Computing devices often rely on voltage converters, also referred to as voltage regulators, to obtain power. For example, direct current (DC)-to-DC voltage converters can convert a power supply at one DC voltage to another, typically lower DC voltage. A voltage converter can convert the main supply voltage of a computing device, such as 12-48 V, down to lower voltages, such as about 1 V. The lower voltages can be used by various components in the computing device, such as a Universal Serial Bus (USB) interface, memory such as dynamic random access memory (DRAM) and processing resources such as a central processing unit (CPU). However, it is challenging to supply power in an efficient and cost-effective manner.

### BRIEF DESCRIPTION OF THE DRAWINGS

The embodiments of the disclosure will be understood more fully from the detailed description given below and from the accompanying drawings of various embodiments of the disclosure, which, however, should not be taken to limit the disclosure to the specific embodiments, but are for explanation and understanding only.
FIG. 1A depicts a cross-sectional view of an example implementation of a stack 100 including a package base layer 110 which includes an inductor L of a voltage regulator (VR) 125, a first die 120 which includes active circuitry 121 of the VR, and a second die 130 which includes a load 131 powered by the VR, wherein a voltage input Vin is provided from the package base layer to the active circuitry, and from the active circuitry to the inductor, in accordance with various embodiments.
FIG. 1B depicts an example circuit diagram of the VR 125 of FIG. 1A, in accordance with various embodiments.
FIG. 2A depicts a cross-sectional view of an example implementation of a stack 200 including a package base layer 210 which includes an inductor L of a voltage regulator (VR) 225, a first die 220 which includes active circuitry 221 of the VR, and a second die 230 which includes a load 231 powered by the VR, wherein a voltage input Vin is provided directly to the inductor in the package base layer without first passing through the first die in accordance with various embodiments.
FIG. 2B depicts a cross-sectional view of an example implementation of a stack 250 similar to the stack 200 of FIG. 2A, where capacitors 222 represent deep-trench capacitors or other embedded capacitors which are part of the active circuitry 221 of the VR 225, in accordance with various embodiments.
FIG. 3 depicts a circuit diagram of a Kappa VR 300 as an example implementation of the VR 225 of FIG. 2A, in accordance with various embodiments.
FIG. 4 depicts plots of efficiency versus load current for the Kappa VR of FIG. 3, where the inductors L1 and L2 have a same inductance (plot 400) and where the inductance of L1 is greater than the inductance of L2 by a ratio of 3:1 (plot 410), in accordance with various embodiments.
FIG. 5A depicts a circuit diagram of a VR 500 which includes the Kappa VR 300 of FIG 3 followed by a set of current multipliers 510, as another example implementation of the VR 225 of FIG. 2A, in accordance with various embodiments.
FIG. 5B depicts a circuit diagram of an example implementation of a current multiplier of FIG. 5A as a switched-capacitor voltage down converter, in accordance with various embodiments.
FIG. 5C depicts example control signals for the set of current multipliers 510 of FIG. 5A, in accordance with various embodiments.
FIG. 6 depicts example plots of efficiency versus load current for various implementations of the Kappa VR of FIG. 3 and 5A, in accordance with various embodiments.
FIG. 7 depicts a circuit diagram of a VR 700 which includes a VR 750 as a switched-inductor-capacitor converter cascaded with a set of 3:1 switched capacitor current multipliers 730, as another example implementation of the VR 225 of FIG. 2A, in accordance with various embodiments.
FIG. 8A depicts a circuit diagram of a VR 800 which includes the Kappa VR 300 of FIG. 3 followed by a Continuously Scalable Conversion Ratio (CSCR) capacitive regulator 810, as another example implementation of the VR 225 of FIG. 2A, in accordance with various embodiments.
FIG. 8B depicts a circuit diagram of an example implementation of the CSCR capacitive regulator 810 of FIG. 8A, in accordance with various embodiments.
FIG. 9 illustrates an example of components that may be present in a computing system 950 for implementing the techniques (e.g., operations, processes, methods, and methodologies) described herein.

### DETAILED DESCRIPTION

With the ever-increasing power demands of workloads and large compute complex sizes, the industry is moving towards 3D-integration with integrated voltage regulators (VRs).

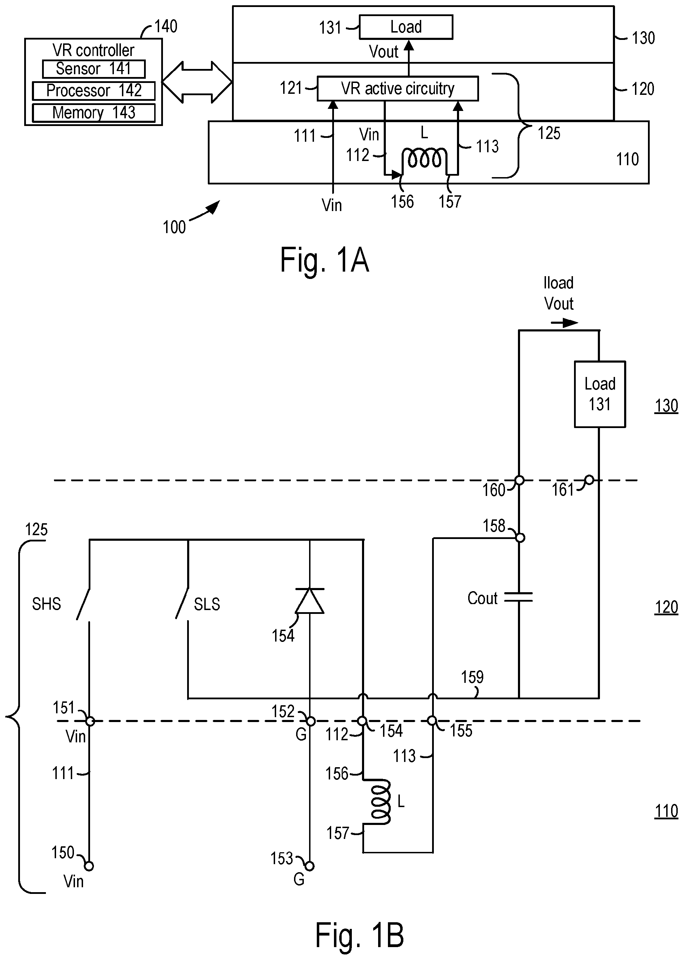

In one possible approach, the VR is placed directly underneath the load. This approach is more amenable to scaling up in both area and power. For example, vertical power delivery architectures using a buck converter can have the active circuitry on a base die combined with a high-quality factor (Q) inductor in a package base layer, below the base die. In this configuration, the power flows into the base die, comes back down to the inductor in the package base layer and then goes back up through the base die to the load on the top die. See also FIG. 1A. The roundabout route taken by the power flowing from the package base layer to the load can lead to excessive conduction loss, which is made worse by the need to partition vertical conduction resources such as through-silicon vias (TSVs), package vias and bumps between the various upward and downward paths. In addition, the input current of a buck converter is discontinuous, leading to the need for substantial decoupling capacitance on the package base layer and/or die.

Generally, inductors in a VR can be integrated on the top metal layers of the base die with or without a magnetic core, which keeps power flow unidirectional. However, on-chip inductors are significantly worse both in terms of current density and losses, due to the relatively low permeability of magnetics available for integration, as well as the relative thinness of even the top metal layers on the die that increases resistance.

Alternatively, switched capacitor-based topologies can be used on the base die power converter using integrated capacitors. However, hard-switched capacitive topologies usually are limited in current density since the converter's losses increase with the depth of discharge in a switching cycle, which increases with current. Further, higher voltage-rated integrated capacitors typically have very low capacitance density, which limits capacitive VRs to lower input voltages to maintain reasonable current density.

The solutions provided herein address the above and other disadvantages. In one aspect, a step-down converter topology is provided with an inductor on the input side of the VR. The high-Q inductor can be implemented inside the package base layer as, e.g., a coaxial, or horizontal or vertical solenoid with or without magnetic materials, with power flowing up into the active converter circuitry on the base die and on to the load die on top. These converters can be cascaded with a downstream current multiplier stage (such as an N:1 unregulated switched capacitor converter) integrated on either die that reduces the voltage down-conversion burden on the inductor-first VR on the base die. Further, in one such topology that has inductors both on the input (Vin) and return (Vss) paths, known as the Kappa converter, asymmetry between inductors can be used to improve efficiency under high conversion ratios.

The solutions provide a number of advantages. For example, regarding inductor size, since the input current is lower than the output current in a voltage step-down converter, moving the inductor to the input side reduces the inductor current, reducing inductor size and cost and lowering losses. Moreover, the addition of a current multiplier stage on the output side further reduces the current conduction losses through the inductor.

Additionally, Electromagnetic Interference (EMI) and Radio Frequency Interference (RMI) can be reduced, along with cost. The presence of an explicit inductor on the input side makes it easy to absorb parasitic inductances on the input of the converter into its operation, which can lower cost by allowing for higher parasitics and/or smaller decoupling capacitors. Also, converters with an inductor on the input side have a continuous input current, which improves EMI/RFI generated by the converter. These advantages also allow for the converter to be directly interfaced to the battery or other primary energy source of the system.

A further advantage is unidirectional power flow. Specifically, power flowing vertically from the package base layer through the VR on the base die to the top die, lowers losses and reduces the need for high-density, low-resistance vertical conduction paths such as TSV arrays through the base die.

These and other features will be further apparent in view of the following discussion.

FIG. 1A depicts a cross-sectional view of an example implementation of a stack 100 including a package base layer 110 which includes an inductor L of a voltage regulator (VR) 125, a first die 120 which includes active circuitry 121 of the VR, and a second die 130 which includes a load 131 powered by the VR, wherein a voltage input Vin is provided from the package base layer to the active circuitry, and from the active circuitry to the inductor, in accordance with various embodiments.

The active circuitry can include, e.g., switches, which interact with passive devices such as capacitors and/or inductors as charge-storing elements. A VR controller 140 (a control circuit) is configured to control the VR such as by specifying a duty cycle for the switches. A VR controller includes a sensor 141, a processor 142 and a memory 143. The memory stores instructions to be executed by the processor. The sensor is capable of sensing an output voltage of the VR and implementing a control loop to regulate the output voltage. The VR controller may in turn communicate with a Power Management Unit (PMU). A PMU can be provided as a microcontroller that governs various power functions such as charging batteries, controlling power to other integrated circuits, shutting down unnecessary system components when they are left idle, and controlling sleep and power functions. The PMU can communicate with one or more VRs such as to coordinate Dynamic Voltage and Frequency Scaling (DVFS) and other efficiency measures. DVFS involves adjusting power and speed settings on a computing device's processors, controller chips and peripheral devices to optimize resource allotment for tasks and maximize power saving when those resources are not needed. The PMU can be provided on a system-on-a-chip (SoC), in one possible approach, which is external to the stack.

In this example, the VR uses an inductor L in the package base layer to transfer charge from an input voltage, Vin, to provide an output voltage Vout for use by the load. The inductor can be embedded inside the package base layer. In one approach, the inductor is formed from conductive traces in the package base layer. Vin may be provided on a conductive path 111 which extends in the package base layer up to the VR active circuitry in the first die 120. The VR active circuitry performs functions such as switching to couple Vin to an input end 156 of the inductor via a conductive path 112 which extends down from the first die to the package base layer. An output end 157 of the inductor is then coupled to a conductive path 113 which extends upward in the package base layer back to the active circuitry. The active circuitry performs functions such as switching to couple charge which is stored by the inductor to an output node to provide Vout to the load. An input end of an inductor is generally the end that receives an input voltage and the output end of an inductor is the end that provides an output voltage, which is less than the input voltage in the case of a buck converter. The output voltage can be set based on the duty cycle of the control signals which turn on or off one or more switches.

As mentioned, in this configuration, the power flows into the base die (first die), comes back down to the inductor in the package base layer and then goes back up through the base die to the load on the top die. The roundabout route taken by the power flowing from the package base layer to the load can lead to excessive conduction loss,

FIG. 1B depicts an example circuit diagram of the VR 125 of FIG. 1A, in accordance with various embodiments. The VR includes a first part in the package base layer and a second part in the first die, in this example. The two parts are connected by nodes/conductive points 151 and 152 such as micro bumps between the package base layer and the die. The first die comprises two switches, including a high-side switch SHS and a low-side switch SLS in this example. The inductor L has an input end 156 and an output end 157. The input end 156 is coupled by SHS to the node 151, which receives Vin via an input node 150 and the path 111. The input end 156 is also coupled by SLS to ground nodes 152 and 153. A diode 154 is coupled between ground and the input end of the inductor. The output end 157 of the inductor is coupled to an output node 158 of the VR via the conductive point 155 to provide Vout to the load 131 via a node 160, which in turn is coupled to the ground node 152 by a node 161 and a ground path 159. The nodes/conductive points 160 and 161 are between the first and second die.

When SHS is closed, SLS is open, and charge is stored in the inductor. When SHS is open, SLS is closed, and charge is transferred from the inductor to ground. SHS and SLS are controlled according to a duty cycle such that a larger duty cycle results in a larger Vout.

Vin can be provided by a power source on, or external to, the package base layer.

The package base layer which can be mounted on a circuit board such as a motherboard or other printed circuit board and includes, on its underside, conductive points such as a ball grid array for communicating with circuits on the board. The package base layer can include conductive paths such as vias to couple the conductive points to an overlying first die such as to input a voltage or ground the VR. Each die in turn can similarly include conductive points on its underside to connect to an underlying layer/die. The package base layer itself can be considered to be a high-density circuit board.

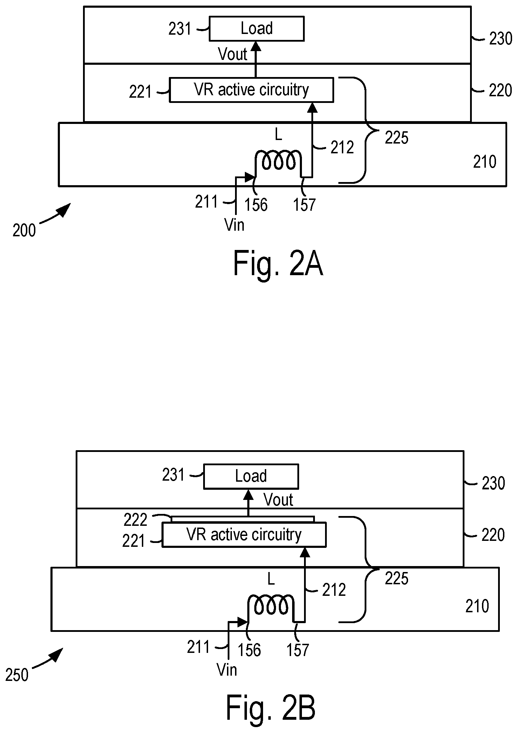

FIG. 2A depicts a cross-sectional view of an example implementation of a stack 200 including a package base layer 210 which includes an inductor L of a voltage regulator (VR) 225, a first die 220 which includes active circuitry 221 of the VR, and a second die 230 which includes a load 231 powered by the VR, wherein a voltage input Vin is provided directly to the inductor in the package base layer without first passing through the first die in accordance with various embodiments.

Vin is provided on an input path 211 directly to the first end 156 of the inductor, where the input path does not enter the first die and remains entirely within the package base layer. The output end 157 of the inductor is coupled to the active circuitry 221 via a path 212 which extends upward from the inductor to the first die. By directly coupling the input voltage to the input end of the inductor, a number of advantages can be achieved, as discussed previously.

The die 220 and 230 can comprise different materials. For example, the die 220 can comprise a Gallium Nitride (GaN) substrate which can handle a relatively high voltage domain, while the die 230 can comprise a silicon substrate which can handle a relatively low voltage domain. Thus, apart from standard complementary metal-oxide semiconductor (CMOS) semiconductor technology, the first die could instead use a GaN or other high-voltage compatible process node that allows for the first stage of the converter with the inductor on the input to operate from a higher input voltage. This is beneficial, e.g., if the system is to be interfaced directly to a 2S/3S battery (two or three batteries arranged serially) that can go as high as 20 V and the switches need to block the same without compromising performance.

FIG. 2B depicts a cross-sectional view of an example implementation of a stack 250 similar to the stack 200 of FIG. 2A, where capacitors 222 represent deep-trench capacitors or other embedded capacitors which are part of the active circuitry 221 of the VR 225, in accordance with various embodiments. Various capacitor options are possible for a 3D-integrated input-inductor-first VR. For example, in addition to package component or on-die capacitors, the options for various flying capacitors in the converter topologies presented herein could include embedded package capacitors or deep-trench capacitors (DTCs). The capacitors 222 are provided in the first die in this example, but could be in another location.

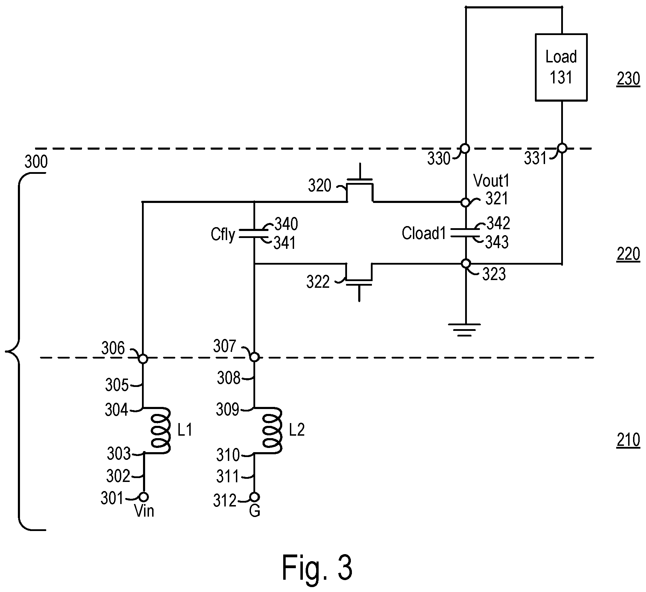

FIG. 3 depicts a circuit diagram of a Kappa VR 300 as an example implementation of the VR 225 of FIG. 2A, in accordance with various embodiments. Generally, a Kappa VR can be configured for step-down (buck), step-up (boost), or buck-boost operation. The Kappa converter circuit exhibits lower electromagnetic interference (EMI) relative to other buck, boost, or buck-boost topologies, along with a high-power handling capability. The Kappa VR includes isolating inductors at its input and ground nodes to reduce signal bounce.

The converter includes two inductors, L1 and L2, which can be integrated in the base package layer 210, a flying capacitor Cfly in the first die, and first and second switches 320 and 322, respectively, which are implemented as n-type metal-oxide-semiconductor field-effect transistors or nMOSFETs in this example. Generally, the switches may be MOSFETs, BJTs, or relay switches, for example. These switches can work out-of-phase, which means the first switch is closed (conductive) when the second switch is open (non-conductive) and the first switch is open when the second switch is closed.

The flying capacitor can be integrated on-chip, in the first die 220, or it can be an off-chip package capacitor. The conversion ratio of the VR is defined as: Vout/Vin=D, where D is the duty cycle of a pulse-width modulation (PWM) signal controlling the first switch. With a low number of switches, e.g., two, the Kappa converter can be implemented with the same area as the conventional buck converter and retains the benefit of reducing the conduction loss from the input inductor. The voltage ratings on both switches are Vin, which is the same as for a buck converter.

In further detail, an input voltage Vin at an input node 301 is coupled on a conductive path 302 to an input end 303 of L1, and the output end 304 of L1 is coupled on a conductive path 305 to a node 306 between the package base layer and the first die. The node 306 is coupled to a first side 340 of Cfly and to a drain side of the nMOS switch 320. The second side 341 of Cfly is coupled to a drain side of the nMOS switch 322 and to a node 307. The node 307 is coupled via a conductive path 308 to an input end 309 of L2, and an output end 310 of L2 is coupled to a ground node 312 via a conductive ground path 311.

A source side of the nMOS switch 320 is coupled to an output node 321 of the VR, while a source side of the nMOS switch 322 is coupled to a ground node 323. The ground node 323 can optionally be coupled to a ground node of the package base layer. A first load capacitor, or output capacitor, Cload1 is coupled between the nodes 321 and 323, where a first side 342 of Cload1 is coupled to the node 321, and a second side 343 of Cload1 is coupled to node 323. The output node 321 is coupled to the load 131 in the second die 230 via a node 330, and the load is also coupled to the ground node 323 via a node 331.

The nodes/conductive points 306 and 307 are between the package base layer and the first die, while the nodes/conductive points 330 and 331 are between the first and second die.

The Kappa VR is an inductor-first VR since the first inductor L1 receives the input voltage Vin directly from a conductive path 302 in the package base layer which does not enter the first die. Also, in some cases, there is no switch between the input node and the first inductor, so that the path 302 is an unswitched path. The second inductor L2 is coupled to the ground node 312 directly via a conductive ground path 311 in the package base layer which does not enter the first die. Also, in some case, there is no switch between the ground node and the second inductor, so that the path 311 is an unswitched path.

In an example implementation, the input end of the first inductor is coupled to a voltage input node 301 of the package base layer by an unswitched path 302 in the package base layer, and the output end of the first inductor is coupled to the active circuitry by an unswitched path 305 in the package base layer. Also, the output end of the second inductor is coupled to the ground node 312 of the package base layer by an unswitched path 311 in the package base layer, and the input end of the second inductor is coupled to the active circuitry by an unswitched path 308 in the package base layer.

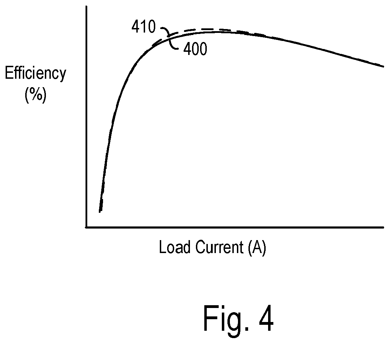

FIG. 4 depicts plots of efficiency versus load current for the Kappa VR of FIG. 3, where the inductors L1 and L2 have a same inductance (plot 400) and where the inductance of L1 is greater than the inductance of L2 by a ratio of 3:1 (plot 410), in accordance with various embodiments. With a single-phase input, the plot 400 represents the case of L1= L2= 4 nH with 10 mΩ. The plot 410 represents the case of L1= 6 nH with 20 mΩ and L2= 2 nH with 10 mΩ, so that the ratio of inductance for L 1 vs. L2 is 3:1.

The plots show that the performance of the Kappa converter can be optimized by introducing asymmetry in the two inductors. In the Kappa converter, the average DC current flow through each inductor can be expressed as: D*Iload for the top inductor L1 and (1-D)*Iload for the bottom inductor L2. Iload is the load current of the converter. In a high-conversion ratio scenario, the duty cycle D can be very small, which leads to a situation where the bottom inductor conducts a major part of the output current and is responsible for a majority of the total inductor loss. In addition, package-integrated inductors tend to have a low inductance (e.g., single-digit nH), and thus high loss due to current ripple. In the Kappa converter, both inductors have the same peak-to-peak AC inductor current. Given the small DC current through L1 because of the small duty cycle, the inductor losses in L1 are dominated by alternating current (AC) losses. Therefore, given a fixed amount of package resources to split between the two inductors L1 and L2, it is more beneficial to design L1 to have a larger inductance at the cost of larger DC resistance to reduce ripple current and AC losses, and vice versa for L2. This assumes the VR provides voltage down conversion.

Plot 410 shows the result of introducing asymmetry between the two inductors. In this example, the inductors are formed coaxially by package vias, with a fixed total via count. In the first scenario (plot 400), the two inductors have equal inductance and equal DC resistance. The second scenario (plot 410) uses a larger inductance and higher DC resistance for the top inductor and a smaller inductance and lower DC resistance for the bottom inductor which is transferring most of DC current. The results shows that the second scenario gains better peak efficiency by reducing the inductor conduction loss. The same idea can be applied for the similar cases of implementing the Kappa converter with integrated planar inductors under constrained total inductor area.

In one approach, wherein the voltage converter is to provide down conversion of a voltage at an input node by a ratio of at least 2:1, e.g., Vin/Vout1, an inductance of the first inductor can be configured to be greater than an inductance of the second inductor. For example, the inductance of the first inductor can be greater than the inductance of the second inductor by a ratio of at least 2:1 or at least 3:1.

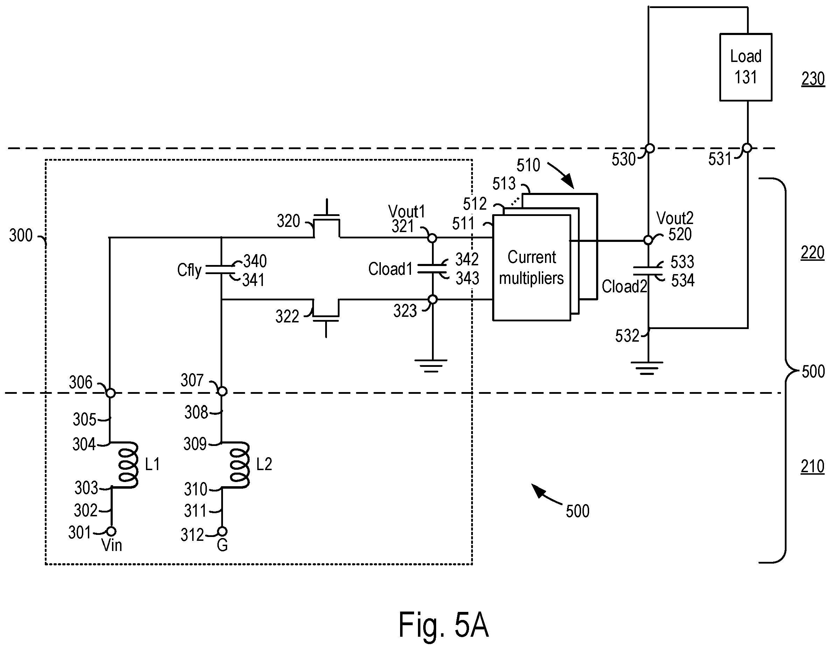

FIG. 5A depicts a circuit diagram of a VR 500 which includes the Kappa VR 300 of FIG 3 followed by a set of current multipliers 510, as another example implementation of the VR 225 of FIG. 2A, in accordance with various embodiments. A current multiplier divides the voltage as it multiplies the current. The set of current multipliers includes example current multipliers 511, 512, ..., 513. Outputs of the different current multipliers are provided to an output node 520, which in turn is coupled to the load 131 via a node 530. The load is also coupled to a ground node 532 via a node 531. A second load capacitor, Cload2, is coupled between the nodes 520 and 532, where a first side 533 of Cload2 is coupled to the node 520, and a second side 534 of Cload2 is coupled to the node 532. The nodes/conductive points 530 and 531 are between the first and second die.

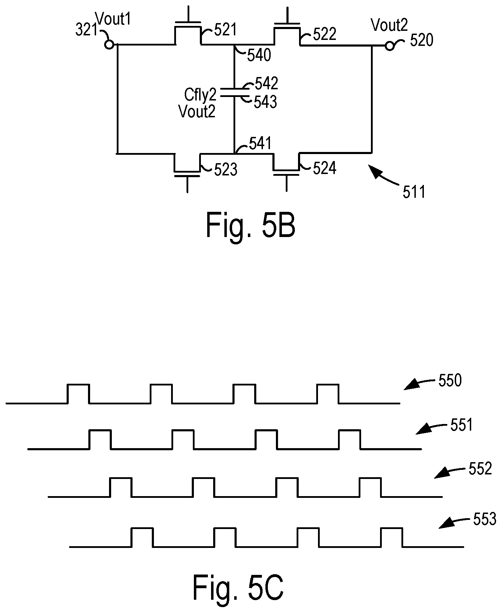

Generally, the set of current multipliers is cascaded with, and downstream of, the VR and its active circuitry. The downstream current multiplier is based on a strategy to alleviate the inductor losses caused by a high conversion ratio and high output current. This approach adds a current multiplier stage at the output of the Kappa converter. In one approach, depicted in FIG. 5B, a cascaded 2:1 switched-capacitor (SC) output stage is added to the Kappa converter. Both stages perform a voltage down conversion. For example, the Kappa converter at the first stage can convert an input voltage Vin such as 3.6 V to an intermediate voltage Vout1 such as 1.4 V, with a 44% duty cycle and 88% efficiency. The current multipliers can down convert the intermediate voltage to a final lower voltage Vout2 such as 0.7 V. This keeps the DC current over the two inductors balanced and reduces loss. In addition, the current supplied by the Kappa converter is halved because of the SC stage which delivers a 2x current multiplication and voltage down conversion, further lowering inductor losses.

The current multipliers can operate at a clock frequency which is greater than a clock frequency of the VR (e.g., the Kappa VR 300) and its active circuitry. In one approach, a first control loop is used to regulate Vout1 and a second control loop is used to regulate Vout2.

FIG. 5B depicts a circuit diagram of an example implementation of a current multiplier of FIG. 5A as a switched-capacitor voltage down converter, in accordance with various embodiments. The current multiplier 511 includes switches (e.g., nMOSFETs) 521 and 522 coupled in series between the input node 321 at Vout1 and the output node 520 at Vout2. Additionally, switches 523 and 524 are coupled in series between the input node 321 and the output node 520. A flying capacitor Cfly2 is coupled at a first side 542 to a node 540 between the switches 521 and 522, and at a second side 543 to a node 541 between the switches 523 and 524.

As mentioned, each current multiplier can provide a 2:1 voltage reduction in this example. The switches of each current multiplier can be controlled so that only one current multiplier is active at a time. The current multipliers are thus phase-interleaved. When a current multiplier is selected by a control signal (see FIG. 5C), it outputs a current to the output node 520. As the current multipliers are consecutively selected, a relatively steady current is output. The load capacitor Cload1 can therefore be made relatively small or even removed while the circuit maintains a steady output.

FIG. 5C depicts example control signals for the set of current multipliers 510 of FIG. 5A, in accordance with various embodiments. The control signals 550, 551, 552 and 553 are for first through fourth current multipliers, respectively. When the signal is high, the switches of the respective current multiplier are turned on so that charge can be transferred from the input node 321 to the flying capacitor Cfly2 and from Cfly2 to the output node 520. This example includes four current multipliers as a simplification but, in practice, many more can be provided to ensure a stable output at the node 520.

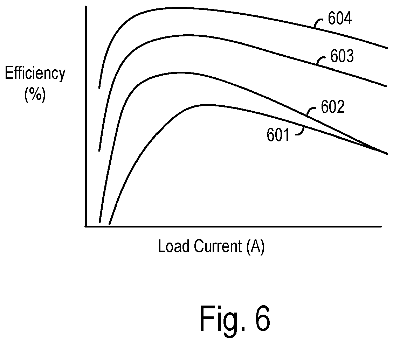

FIG. 6 depicts example plots of efficiency versus load current for various implementations of the Kappa VR of FIG. 3 and 5A, in accordance with various embodiments. The plot 601 shows the case of a single-stage Kappa VR, e.g., the Kappa VR 300 of FIG. 5A, converting 3.6 V to 0.7 V, without the following set of current multipliers 510. The peak efficiency is relatively low in this case since the down conversion ratio is relatively high. The plot 602 shows the combined efficiency of the two-stage VR 500 of FIG. 5A, where the Kappa VR down converts from 3.6 V to 1.4 V and the current multipliers down convert from 1.4 V to 0.7 V. These voltages are merely examples as other voltages can down conversion ratios can be used. The plot 602 is based on multiplying the values of the plots 603 and 604, where the plot 603 is the efficiency of the Kappa VR alone in the two-stage design and the plot 604 is the efficiency of the set of current multipliers alone in the two-stage design. The Kappa VR is more efficient when its down conversion ratio is reduced.

The plots show the efficiency of each stage as well as a combined efficiency vs. a single-stage design. The efficiency of the Kappa converter stage itself is improved because of the less skewed current distribution as well as lower overall current through the inductors. The 2x current multiplier stage can typically be integrated on-chip with high efficiency, leading to significant efficiency improvement for the cascaded design.

Since the switched-capacitor converter at the output is fully integrated on either the base die (first die) or the top die (second die), it can be split into multiple phases that are phase-interleaved and switched at a much higher effective frequency to present a near-continuous current drawn from the first stage. This can help in reducing or omitting the decoupling capacitor Cload1 between the converter stages as well as at the output (Cload2). Compared to the single-stage Kappa converter, a major portion of the output capacitor budget can now be allocated instead to the flying capacitors (Cfly2) of the 2:1 switched-capacitor divider.

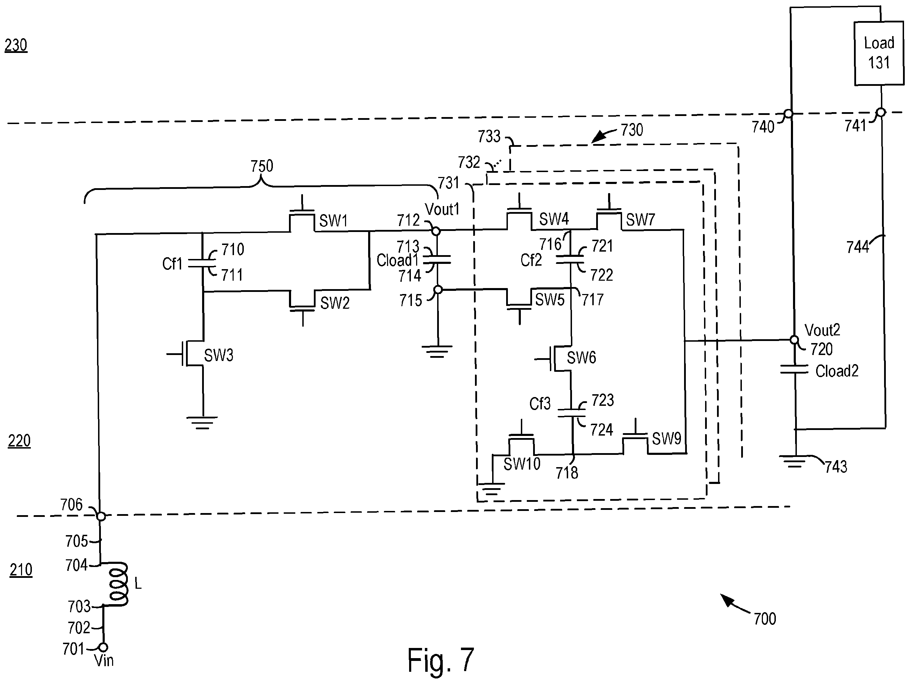

FIG. 7 depicts a circuit diagram of a VR 700 which includes a VR 750 as a switched-inductor-capacitor converter cascaded with a set of 3:1 switched capacitor current multipliers 730, as another example implementation of the VR 225 of FIG. 2A, in accordance with various embodiments.

The solutions can be extended further to other input-inductor-first topologies. This example describes a switched-inductor-capacitor (SIC) converter (e.g., VR 750) cascaded with a 3:1 switched capacitor converter (e.g., a set of 3:1 switched capacitor current multipliers 730). The SIC converter includes the input inductor L, a first flying capacitor Cf1 and three switches, SW1-SW3. The first load capacitor Cload1 acts as the decoupling capacitor between the stages. All components except for the inductor L are integrated on-chip, in one approach. The SIC converter operates by a duty cycle-control PWM signal, divided into two phases. In a charging phase, SW1 and SW3 are turned on to charge the inductor and Cf1. In the discharge phase, SW2 is turned on by an out-of-phase PWM signal to discharge Cf1 to the output. The conversion ratio of the SIC stage is 1/(2-D), where D is the duty cycle of the PWM signal in the charge phase,

The 3:1 SC converter can operate with a separate clock signal that is typically at a higher frequency than a clock signal of the VR 750. The total conversion ratio is 1/3(2-D), which makes this converter capable of conversion ratios between 1/3 and 1/6 and suitable for the 3.6 V-0.7 V conversion application outlined in the previous example. The frequency of each stage can be individually optimized to lower the switching loss and increase the efficiency. The on-chip integrated 3:1 SC converter can also be split into multiple units that are phase-interleaved, which can present a near continuous output current to the SIC and minimize the need for the inter-stage decoupling capacitor Cload1.

In further detail, an input voltage Vin at an input node 701 is coupled on a conductive path 702 to an input end 703 of an inductor L, and the output end 704 of the inductor is coupled on a conductive path 705 to a node 706 between the package base layer and the first die. The node 706 in turn is coupled to a first side 710 of a first flying capacitor Cf1 and to a switch SW1, e.g., to a drain side of an nMOS switch. The second side 711 of Cf1 is coupled to a switch SW3, e.g., to a drain side of an nMOS switch SW3 and to a switch SW2, e.g., to a drain side of an nMOS switch SW2. SW3 is to control whether the second side of Cf1 is grounded. The source sides of SW1 and SW2 are coupled to an output node 712 at a voltage Vout1. A first load capacitor Cload1 is coupled between the node 712 and a ground node 715, where a first side 713 of Cload1 is coupled to the node 712, and a second side 714 of Cload1 is coupled to the node 715.

The nodes 712 and 715 are coupled to a set of current multipliers 730, which include current multipliers 731, 732, ..., 733. Each current multiplier includes two flying capacitors Cf2 and Cf3 and switches for coupling charge to and from the flying capacitors. A first side 721 of Cf2 is coupled to a node 716 between switches SW4 and SW7. A second side 722 of Cf2 is coupled to a node 717 and to SW5, which is between nodes 715 and 717. A first side 724 of Cf3 is coupled to a node 718 between switches SW10 and SW9. A second side 723 of Cf3 can be coupled to the node 717 via SW6. The output node 720 is coupled to SW7 and SW9 of each current multiplier to receive the output voltage Vout2. Vout2 is provided to the load 131 via the node 740. The load is coupled to a ground node 743 via a path 744. In operation, SW4, SW6 and SW9 are on half of a cycle, and SW5, SW7, SW8 and SW10 are on half the other half of the cycle. As noted, the switching frequency can be higher for the current multipliers than for the VR 750.

The nodes/conductive points 740 and 741 are between the first and second die.

In one approach, a set of current multipliers are cascaded with, and downstream of, the active circuitry of the VR, wherein the set of current multipliers are in the one or more die and comprises a plurality of switched-capacitor voltage down converters that are phase-interleaved. Additionally, the set of current multipliers art to operate at a clock frequency which is greater than a clock frequency of the active circuitry.

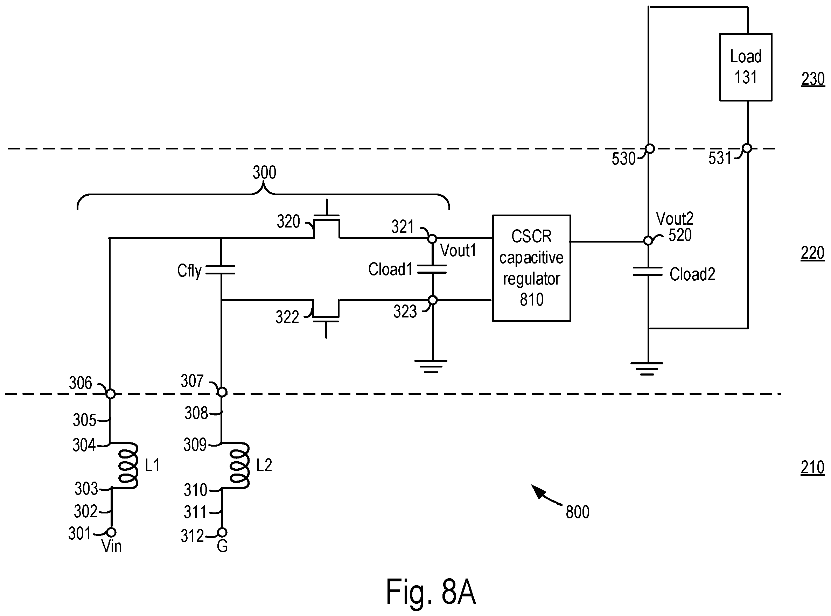

FIG. 8A depicts a circuit diagram of a VR 800 which includes the Kappa VR 300 of FIG. 3 followed by a Continuously Scalable Conversion Ratio (CSCR) capacitive regulator 810, as another example implementation of the VR 225 of FIG. 2A, in accordance with various embodiments. The CSCR capacitive regulator 810 is coupled to the output node 321 at Vout1 and to the ground node 323, e.g., at 0 V.

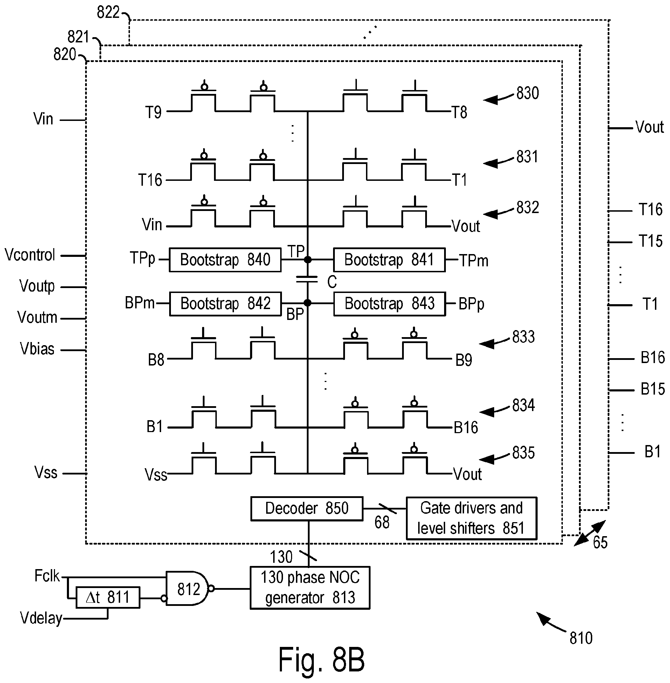

FIG. 8B depicts a circuit diagram of an example implementation of the CSCR capacitive regulator 810 of FIG. 8A, in accordance with various embodiments. A CSCR capacitive regulator uses multiphase soft charging of a capacitor C to provide a continuously scalable conversion-ratio with high efficiency. The basic idea is to maximize the voltage variation of the flying capacitor(s) by making it swing between approximately Vin and 0 V and back, regardless of the output voltage. Opening up the capacitors' voltages to have no fixed bias voltage dramatically increases the number of topologies, especially when also using many phases. To minimize the design complexity, a single-capacitor topology is depicted. For simplicity, it is assumed that the capacitor polarity stays the same over a full cycle.

The regulator includes a number (e.g., 65) of phase-shifted cores 820, 821, ..., 822. Each core includes sets of transistors 830, .., 831 and 832 associated with top side nodes T1 to T16, and sets of transistors 833, .., 834 and 835 associated with bottom side nodes B1 to B16. There are M soft-charging phases at the top side (nodes T1 to TM) and N soft-charging phases at the bottom side, with corresponding nodes B1+BN. The example topology is implemented with N, M = 32. To enable direct charge transfers between capacitors through the soft-charging nodes, the converter is split into 1 + N + M = 65 phase-shifted cores. Due to out-phasing, only 16 top and bottom nodes have to be implemented.

All switches are implemented using two stacked thin-oxide transistors to enable a wide Vout range with a Vin of up to, e.g., 2 V. Furthermore, to maximize their conductance over the entire range, four 3-pF bootstrap capacitors 840, 841, 842 and 843 are used per core, each of which generates a voltage rail relative to the top/bottom plate, T Pp/T Pm, and B Pp/B Pm, that is charged each time this plate connects to Vout using the external Voutp and Voutm rails. These external voltage rails are at a fixed voltage of 1 and -0.85 V relative to Vout. All transistors that connect to a soft-charging node need to block both positive and negative voltages across their drain-source and are, therefore, driven by tristate buffers. An external frequency reference, Fclk, is divided using a non-overlapping clock generator 813 into 130 phases, which are then distributed to each core's local decoder, such as the decoder 850 of the core 820. Fclk is input to an AND gate 812 and a variable delay circuit 811, where the delay is set by Vdelay. The output of the decoder is provided to a gate drivers and level shifters circuit 851.

The Vss connecting transistors together with the clock generator and other logic are powered by Vcontrol = 1.1 V. Vcontrol, Voutp, and Voutm are provided externally for flexibility and measurement purposes, but their peak current consumptions allow them to be generated with classical charge pumps and limited overhead on the chip.

Thus, instead of a current multiplier at the output of the input-inductor converter, a linear or capacitive regulator can be added at the output, such as a Continuously Scalable Conversion Ratio (CSCR) capacitive regulator or a digital or analog linear regulator. In such an implementation, the upstream input-inductor converter can act as a fixed ratio converter without regulation, with the task of voltage regulation pushed to the downstream stage. Having a fully on-chip integrable capacitive or linear downstream stage also affords the advantage of combining multiple small rails to be fed by a single upstream stage, with each rail having its own dedicated downstream regulator that can all be capacitive, linear or a combination of both.

In one approach, the CSCR capacitive regulator is cascaded with, and downstream of, the active circuitry of the voltage converter, wherein the CSCR capacitive regulator is in at least one of the first die or a second die stacked on the first die.

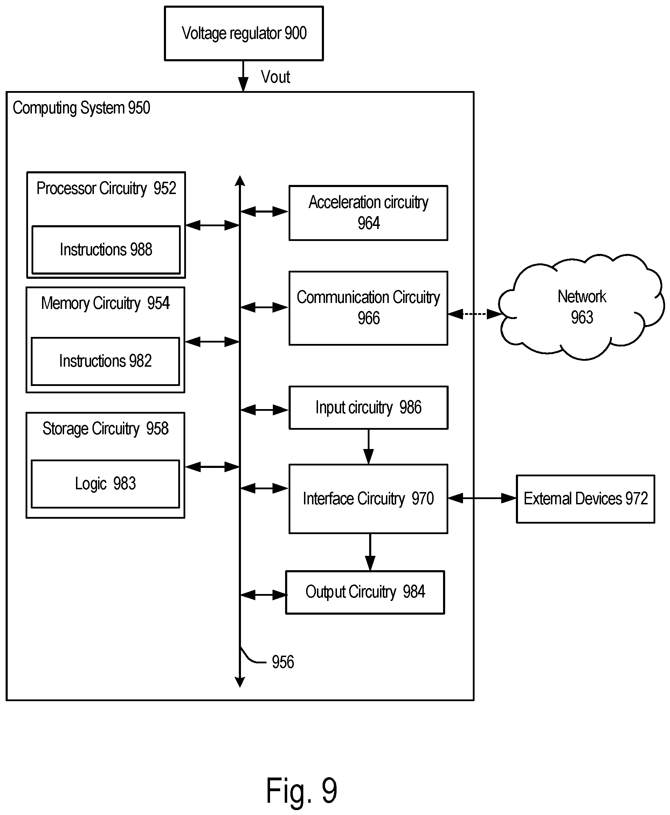

FIG. 9 illustrates an example of components that may be present in a computing system 950 for implementing the techniques (e.g., operations, processes, methods, and methodologies) described herein. The voltage regulator 900 may provide a voltage Vout to one or more of the components of the computing system 950. The voltage regulator 900 may be external to, or part of, the computing system 950. The VR may be controlled by control signals provided by the processor circuitry 952. The VR may include any of the VRs discussed herein including those in FIGs. 2A-3, 5A-5C and 7-8B.

The memory circuitry 954 may store instructions and the processor circuitry 952 may execute the instructions to perform the functions described herein.

The computing system 950 may include any combinations of the hardware or logical components referenced herein. The components may be implemented as ICs, portions thereof, discrete electronic devices, or other modules, instruction sets, programmable logic or algorithms, hardware, hardware accelerators, software, firmware, or a combination thereof adapted in the computing system 950, or as components otherwise incorporated within a chassis of a larger system. For one embodiment, at least one processor 952 may be packaged together with computational logic 982 and configured to practice aspects of various example embodiments described herein to form a System in Package (SiP) or a System on Chip (SoC).

The system 950 includes processor circuitry in the form of one or more processors 952. The processor circuitry 952 includes circuitry such as, but not limited to one or more processor cores and one or more of cache memory, low drop-out voltage regulators (LDOs), interrupt controllers, serial interfaces such as SPI, I2C or universal programmable serial interface circuit, real time clock (RTC), timer-counters including interval and watchdog timers, general purpose I/O, memory card controllers such as secure digital/multi-media card (SD/MMC) or something similar, interfaces, mobile industry processor interface (MIPI) interfaces and Joint Test Access Group (JTAG) test access ports. In some implementations, the processor circuitry 952 may include one or more hardware accelerators (e.g., same as or similar to acceleration circuitry 964), which may be microprocessors, programmable processing devices (e.g., FPGA, ASIC, etc.), or the like. The one or more accelerators may include, for example, computer vision and/or deep learning accelerators. In some implementations, the processor circuitry 952 may include on-chip memory circuitry, which may include any suitable volatile and/or non-volatile memory, such as DRAM, SRAM, EPROM, EEPROM, Flash memory, solid-state memory, and/or any other type of memory device technology, such as those discussed herein.

The processor circuitry 952 may include, for example, one or more processor cores (CPUs), application processors, GPUs, RISC processors, Acorn RISC Machine (ARM) processors, CISC processors, one or more DSPs, one or more FPGAs, one or more PLDs, one or more ASICs, one or more baseband processors, one or more radio-frequency integrated circuits (RFIC), one or more microprocessors or controllers, a multi-core processor, a multithreaded processor, an ultra-low-voltage processor, an embedded processor, or any other known processing elements, or any suitable combination thereof. The processors (or cores) 952 may be coupled with or may include memory/storage and may be configured to execute instructions stored in the memory/storage to enable various applications or operating systems to run on the platform 950. The processors (or cores) 952 is configured to operate application software to provide a specific service to a user of the platform 950. In some embodiments, the processor(s) 952 may be a special-purpose processor(s)/controller(s) configured (or configurable) to operate according to the various embodiments herein.

As examples, the processor(s) 952 may include an Intel^{®} Architecture Core^{™} based processor such as an i3, an i5, an i7, an i9 based processor; an Intel^{®} microcontroller-based processor such as a Quark^{™}, an Atom^{™}, or other MCU-based processor; Pentium^{®} processor(s), Xeon^{®} processor(s), or another such processor available from Intel^{®} Corporation, Santa Clara, California. However, any number other processors may be used, such as one or more of Advanced Micro Devices (AMD) Zen^{®} Architecture such as Ryzen^{®} or EPYC^{®} processor(s), Accelerated Processing Units (APUs), MxGPUs, Epyc^{®} processor(s), or the like; A5-A12 and/or S1-S4 processor(s) from Apple^{®} Inc., Snapdragon^{™} or Centriq^{™} processor(s) from Qualcomm^{®} Technologies, Inc., Texas Instruments, Inc.^{®} Open Multimedia Applications Platform (OMAP)^{™} processor(s); a MIPS-based design from MIPS Technologies, Inc. such as MIPS Warrior M-class, Warrior I-class, and Warrior P-class processors; an ARM-based design licensed from ARM Holdings, Ltd., such as the ARM Cortex-A, Cortex-R, and Cortex-M family of processors; the ThunderX2^{®} provided by Cavium^{™}, Inc.; or the like. In some implementations, the processor(s) 952 may be a part of a system on a chip (SoC), System-in-Package (SiP), a multi-chip package (MCP), and/or the like, in which the processor(s) 952 and other components are formed into a single integrated circuit, or a single package, such as the Edison^{™} or Galileo^{™} SoC boards from Intel^{®} Corporation. Other examples of the processor(s) 952 are mentioned elsewhere in the present disclosure.

The system 950 may include or be coupled to acceleration circuitry 964, which may be embodied by one or more AI/MI, accelerators, a neural compute stick, neuromorphic hardware, an FPGA, an arrangement of GPUs, one or more SoCs (including programmable SoCs), one or more CPUs, one or more digital signal processors, dedicated ASICs (including programmable ASICs), PLDs such as complex (CPLDs) or high complexity PLDs (HCPLDs), and/or other forms of specialized processors or circuitry designed to accomplish one or more specialized tasks. These tasks may include AI/MI, processing (e.g., including training, inferencing, and classification operations), visual data processing, network data processing, object detection, rule analysis, or the like. In FPGA-based implementations, the acceleration circuitry 964 may comprise logic blocks or logic fabric and other interconnected resources that may be programmed (configured) to perform various functions, such as the procedures, methods, functions, etc. of the various embodiments discussed herein. In such implementations, the acceleration circuitry 964 may also include memory cells (e.g., EPROM, EEPROM, flash memory, static memory (e.g., SRAM, antifuses, etc.) used to store logic blocks, logic fabric, data, etc. in LUTs and the like.

In some implementations, the processor circuitry 952 and/or acceleration circuitry 964 may include hardware elements specifically tailored for machine learning and/or artificial intelligence (AI) functionality. In these implementations, the processor circuitry 952 and/or acceleration circuitry 964 may be, or may include, an AI engine chip that can run many different kinds of AI instruction sets once loaded with the appropriate weightings and training code. Additionally or alternatively, the processor circuitry 952 and/or acceleration circuitry 964 may be, or may include, AI accelerator(s), which may be one or more of the aforementioned hardware accelerators designed for hardware acceleration of AI applications. As examples, these processor(s) or accelerators may be a cluster of artificial intelligence (AI) GPUs, tensor processing units (TPUs) developed by Google^{®} Inc., Real AI Processors (RAPs^{™}) provided by AlphaICs^{®}, Nervana^{™} Neural Network Processors (NNPs) provided by Intel^{®} Corp., Intel^{®} Movidius^{™} Myriad^{™} X Vision Processing Unit (VPU), NVIDIA^{®} PX^{™} based GPUs, the NM500 chip provided by General Vision^{®}, Hardware 3 provided by Tesla^{®}, Inc., an Epiphany^{™} based processor provided by Adapteva^{®}, or the like. In some embodiments, the processor circuitry 952 and/or acceleration circuitry 964 and/or hardware accelerator circuitry may be implemented as AI accelerating co-processor(s), such as the Hexagon 685 DSP provided by Qualcomm^{®}, the PowerVR 2NX Neural Net Accelerator (NNA) provided by Imagination Technologies Limited^{®}, the Neural Engine core within the Apple^{®} A11 or A12 Bionic SoC, the Neural Processing Unit (NPU) within the HiSilicon Kirin 970 provided by Huawei^{®}, and/or the like. In some hardware-based implementations, individual subsystems of system 950 may be operated by the respective AI accelerating co-processor(s), AI GPUs, TPUs, or hardware accelerators (e.g., FPGAs, ASICs, DSPs, SoCs, etc.), etc., that are configured with appropriate logic blocks, bit stream(s), etc. to perform their respective functions.

The system 950 also includes system memory 954. Any number of memory devices may be used to provide for a given amount of system memory. As examples, the memory 954 may be, or include, volatile memory such as random access memory (RAM), static RAM (SRAM), dynamic RAM (DRAM), synchronous DRAM (SDRAM), RAMBUS^{®} Dynamic Random Access Memory (RDRAM^{®}), and/or any other desired type of volatile memory device. Additionally or alternatively, the memory 954 may be, or include, non-volatile memory such as read-only memory (ROM), erasable programmable ROM (EPROM), electrically erasable programmable (EEPROM), flash memory, non-volatile RAM, ferroelectric RAM, phase-change memory (PCM), flash memory, and/or any other desired type of non-volatile memory device. Access to the memory 954 is controlled by a memory controller. The individual memory devices may be of any number of different package types such as single die package (SDP), dual die package (DDP) or quad die package (Q17P). Any number of other memory implementations may be used, such as dual inline memory modules (DIMMs) of different varieties including but not limited to microDIMMs or MiniDIMMs.

Storage circuitry 958 provides persistent storage of information such as data, applications, operating systems and so forth. In an example, the storage 958 may be implemented via a solid-state disk drive (SSDD) and/or high-speed electrically erasable memory (commonly referred to as "flash memory"). Other devices that may be used for the storage 958 include flash memory cards, such as SD cards, microSD cards, XD picture cards, and the like, and USB flash drives. In an example, the memory device may be or may include memory devices that use chalcogenide glass, multi-threshold level NAND flash memory, NOR flash memory, single or multi-level Phase Change Memory (PCM), a resistive memory, nanowire memory, ferroelectric transistor random access memory (FeTRAM), anti-ferroelectric memory, magnetoresistive random access memory (MRAM) memory that incorporates memristor technology, phase change RAM (PRAM), resistive memory including the metal oxide base, the oxygen vacancy base and the conductive bridge Random Access Memory (CB-RAM), or spin transfer torque (STT)-MRAM, a spintronic magnetic junction memory based device, a magnetic tunneling junction (MTJ) based device, a Domain Wall (DW) and Spin Orbit Transfer (SOT) based device, a thyristor based memory device, a hard disk drive (HDD), micro HDD, of a combination thereof, and/or any other memory. The memory circuitry 954 and/or storage circuitry 958 may also incorporate three-dimensional (3D) cross-point (XPOINT) memories from Intel^{®} and Micron^{®}.

The memory circuitry 954 and/or storage circuitry 958 is/are configured to store computational logic 983 in the form of software, firmware, microcode, or hardware-level instructions to implement the techniques described herein. The computational logic 983 may be employed to store working copies and/or permanent copies of programming instructions, or data to create the programming instructions, for the operation of various components of system 950 (e.g., drivers, libraries, application programming interfaces (APIs), etc.), an operating system of system 950, one or more applications, and/or for carrying out the embodiments discussed herein. The computational logic 983 may be stored or loaded into memory circuitry 954 as instructions 982, or data to create the instructions 982, which are then accessed for execution by the processor circuitry 952 to carry out the functions described herein. The processor circuitry 952 and/or the acceleration circuitry 964 accesses the memory circuitry 954 and/or the storage circuitry 958 over the interconnect (IX) 956. The instructions 982 direct the processor circuitry 952 to perform a specific sequence or flow of actions, for example, as described with respect to flowchart(s) and block diagram(s) of operations and functionality depicted previously. The various elements may be implemented by assembler instructions supported by processor circuitry 952 or high-level languages that may be compiled into instructions 988, or data to create the instructions 988, to be executed by the processor circuitry 952. The permanent copy of the programming instructions may be placed into persistent storage devices of storage circuitry 958 in the factory or in the field through, for example, a distribution medium (not shown), through a communication interface (e.g., from a distribution server (not shown)), over-the-air (OTA), or any combination thereof.

The IX 956 couples the processor 952 to communication circuitry 966 for communications with other devices, such as a remote server (not shown) and the like. The communication circuitry 966 is a hardware element, or collection of hardware elements, used to communicate over one or more networks 963 and/or with other devices. In one example, communication circuitry 966 is, or includes, transceiver circuitry configured to enable wireless communications using any number of frequencies and protocols such as, for example, the Institute of Electrical and Electronics Engineers (IEEE) 802.11 (and/or variants thereof), IEEE 802.23.4, Bluetooth^{®} and/or Bluetooth^{®} low energy (BLE), ZigBee^{®}, LoRaWAN^{™} (Long Range Wide Area Network), a cellular protocol such as 3GPP LTE and/or Fifth Generation (5G)/New Radio (NR), and/or the like. Additionally or alternatively, communication circuitry 966 is, or includes, one or more network interface controllers (NICs) to enable wired communication using, for example, an Ethernet connection, Controller Area Network (CAN), Local Interconnect Network (LIN), DeviceNet, ControlNet, Data Highway+, or PROFINET, among many others.

The IX 956 also couples the processor 952 to interface circuitry 970 that is used to connect system 950 with one or more external devices 972. The external devices 972 may include, for example, sensors, actuators, positioning circuitry (e.g., global navigation satellite system (GNSS)/Global Positioning System (GPS) circuitry), client devices, servers, network appliances (e.g., switches, hubs, routers, etc.), integrated photonics devices (e.g., optical neural network (ONN) integrated circuit (IC) and/or the like), and/or other like devices.

In some optional examples, various input/output (I/O) devices may be present within or connected to, the system 950, which are referred to as input circuitry 986 and output circuitry 984. The input circuitry 986 and output circuitry 984 include one or more user interfaces designed to enable user interaction with the platform 950 and/or peripheral component interfaces designed to enable peripheral component interaction with the platform 950. Input circuitry 986 may include any physical or virtual means for accepting an input including, inter alia, one or more physical or virtual buttons (e.g., a reset button), a physical keyboard, keypad, mouse, touchpad, touchscreen, microphones, scanner, headset, and/or the like. The output circuitry 984 may be included to show information or otherwise convey information, such as sensor readings, actuator position(s), or other like information. Data and/or graphics may be displayed on one or more user interface components of the output circuitry 984. Output circuitry 984 may include any number and/or combinations of audio or visual display, including, inter alia, one or more simple visual outputs/indicators (e.g., binary status indicators (e.g., light emitting diodes (LEDs)) and multi-character visual outputs, or more complex outputs such as display devices or touchscreens (e.g., Liquid Crystal Displays (LCD), LED displays, quantum dot displays, projectors, etc.), with the output of characters, graphics, multimedia objects, and the like being generated or produced from the operation of the platform 950. The output circuitry 984 may also include speakers and/or other audio emitting devices, printer(s), and/or the like. Additionally or alternatively, sensor(s) may be used as the input circuitry 984 (e.g., an image capture device, motion capture device, or the like) and one or more actuators may be used as the output device circuitry 984 (e.g., an actuator to provide haptic feedback or the like). Peripheral component interfaces may include, but are not limited to, a non-volatile memory port, a USB port, an audio jack, a power supply interface, etc. In some embodiments, a display or console hardware, in the context of the present system, may be used to provide output and receive input of an edge computing system; to manage components or services of an edge computing system; identify a state of an edge computing component or service; or to conduct any other number of management or administration functions or service use cases.

The components of the system 950 may communicate over the IX 956. The IX 956 may include any number of technologies, including ISA, extended ISA, I2C, SPI, point-to-point interfaces, power management bus (PMBus), PCI, PCIe, PCIx, Intel^{®} UPI, Intel^{®} Accelerator Link, Intel^{®} CXL, CAPI, OpenCAPI, Intel^{®} QPI, UPI, Intel^{®} OPA IX, RapidIO^{™} system IXs, CCIX, Gen-Z Consortium IXs, a HyperTransport interconnect, NVLink provided by NVIDIA^{®}, a Time-Trigger Protocol (TTP) system, a FlexRay system, PROFIBUS, and/or any number of other IX technologies. The IX 956 may be a proprietary bus, for example, used in a SoC based system.

The number, capability, and/or capacity of the elements of system 950 may vary, depending on whether computing system 950 is used as a stationary computing device (e.g., a server computer in a data center, a workstation, a desktop computer, etc.) or a mobile computing device (e.g., a smartphone, tablet computing device, laptop computer, game console, IoT device, etc.). In various implementations, the computing device system 950 may comprise one or more components of a data center, a desktop computer, a workstation, a laptop, a smartphone, a tablet, a digital camera, a smart appliance, a smart home hub, a network appliance, and/or any other device/system that processes data.

The techniques described herein can be performed partially or wholly by software or other instructions provided in a machine-readable storage medium (e.g., memory). The software is stored as processor-executable instructions (e.g., instructions to implement any other processes discussed herein). Instructions associated with the flowchart (and/or various embodiments) and executed to implement embodiments of the disclosed subject matter may be implemented as part of an operating system or a specific application, component, program, object, module, routine, or other sequence of instructions or organization of sequences of instructions.

The storage medium can be a tangible, non-transitory machine readable medium such as read only memory (ROM), random access memory (RAM), flash memory devices, floppy and other removable disks, magnetic storage media, optical storage media (e.g., Compact Disk Read-Only Memory (CD ROMS), Digital Versatile Disks (DVDs)), among others.

The storage medium may be included, e.g., in a communication device, a computing device, a network device, a personal digital assistant, a manufacturing tool, a mobile communication device, a cellular phone, a notebook computer, a tablet, a game console, a set top box, an embedded system, a TV (television), or a personal desktop computer.

Some non-limiting examples of various embodiments are presented below.

Example 1 includes an apparatus, comprising: a package base layer; a first die stacked on the package base layer; and a voltage converter comprising a first inductor, an input node and an input path in the package base layer, and active circuitry in the first die, wherein the input path is to couple the input node to an input end of the first inductor without entering the first die, and the active circuitry is coupled to an output end of the first inductor.

Example 2 includes the apparatus of Example 1, wherein a load of the voltage converter is in at least one of the first die or a second die stacked on the first die.

Example 3 includes the apparatus of Example 1 or 2, wherein a load of the voltage converter is in a second die stacked on the first die, the first die comprises a gallium nitride substrate and the second die comprises a silicon substrate.

Example 4 includes the apparatus of any one of Examples 1-3, further comprising a set of current multipliers cascaded with, and downstream of, the active circuitry of the voltage converter, wherein the set of current multipliers is in at least one of the first die or a second die stacked on the first die.

Example 5 includes the apparatus of Example 4, wherein the set of current multipliers comprises a plurality of switched-capacitor voltage down converters that are phase-interleaved.

Example 6 includes the apparatus of any one of Examples 1-5, further comprising a Continuously Scalable Conversion Ratio (CSCR) capacitive regulator cascaded with, and downstream of, the active circuitry of the voltage converter, wherein the CSCR capacitive regulator is in at least one of the first die or a second die stacked on the first die.

Example 7 includes the apparatus of any one of Examples 1-6, wherein: the voltage converter comprises a second inductor, a ground node and a ground path in the package base layer; the ground path is to couple the ground node to an output end of the second inductor without entering the first die; and the active circuitry is coupled to an input end of the second inductor.

Example 8 includes the apparatus of Example 7, wherein the voltage converter is to provide down conversion of a voltage at the input node by a ratio of at least 2:1, and an inductance of the first inductor is greater than an inductance of the second inductor.

Example 9 includes the apparatus of Example 8, wherein the inductance of the first inductor is greater than the inductance of the second inductor by a ratio of at least 2:1.

Example 10 includes the apparatus of any one of Examples 7-9, wherein the active circuitry comprises: a flying capacitor having a first side coupled to the output end of the first inductor and a second side coupled to the input end of the second inductor; a first switch to couple the first side of the flying capacitor to an output node of the voltage converter; and a second switch to couple the second side of the flying capacitor to a ground node.

Example 11 includes the apparatus of Example 10, wherein the flying capacitor comprises an embedded package capacitor or a deep-trench capacitor.

Example 12 includes the apparatus of any one of Examples 1-11, further comprising at least one of an integrated circuit, a System on Chip, a System in Package or a computing device in which the package base layer, first die and voltage converter are provided, wherein the computing device comprises circuitry of at least one of a processor circuitry, a memory circuitry, a storage circuitry, an acceleration circuitry, a communication circuitry, an input circuitry, an output circuitry, an interface circuitry or an external device.

Example 13 includes an apparatus, comprising: a package base layer; a first die stacked on the package base layer; and an inductor-first voltage converter, wherein the inductor-first voltage converter comprises a first inductor in the package base layer and active circuitry in the first die, the first inductor is coupled to an input node of the package base layer, and the active circuitry is coupled to the first inductor.

Example 14 includes the apparatus of Example 13, wherein the inductor-first voltage converter is a Kappa voltage converter.

Example 15 includes the apparatus of Example 14, wherein: the inductor-first voltage converter further comprises a second inductor in the package base layer; the second inductor is coupled to a ground node of the package base layer; and the active circuitry is coupled to the second inductor.

Example 16 includes the apparatus of any one of Examples 13-15, wherein the inductor-first voltage converter is a switched-capacitor voltage converter.

Example 17 includes the apparatus of Example 16, wherein the active circuitry comprises: a flying capacitor having a first side coupled to the first inductor; a first switch to couple the first side of the flying capacitor to an output node of the inductor-first voltage converter; a second switch to couple a second side of the flying capacitor to the output node; and a third switch to couple the second side of the flying capacitor to a ground node.

Example 18 includes an apparatus, comprising: a first inductor in a package base layer of a stack; and active circuitry in one or more die of the stack, wherein: the one or more die are above the package base layer in the stack; an input end of the first inductor is coupled to a voltage input node of the package base layer by an unswitched path in the package base layer; and an output end of the first inductor is coupled to the active circuitry by an unswitched path in the package base layer.

Example 19 includes the apparatus of Example 18, further comprising a set of current multipliers cascaded with, and downstream of, the active circuitry, wherein the set of current multipliers are in the one or more die and comprises a plurality of switched-capacitor voltage down converters that are phase-interleaved.

Example 20 includes the apparatus of Example 18 or 19, further comprising a set of current multipliers cascaded with, and downstream of, the active circuitry, wherein the set of current multipliers are to operate at a clock frequency which is greater than a clock frequency of the active circuitry.

Example 21 includes a method, comprising: receiving an input voltage at an input end of an inductor of a voltage regulator in a package base layer; outputting an output voltage at an output end of the inductor in the package base layer; coupling the output voltage to active circuitry of the voltage regulator in a first die stacked on the package base layer.

Example 22 includes the method of Example 21, further comprising down converting the output voltage at the first die to provide an output voltage to a load.

Example 23 includes a non-transitory machine-readable storage including machine-readable instructions that, when executed, cause a processor or other circuit or computing device to implement the method of Example 21 or 22.

Example 24 includes a computer program comprising instructions which, when the program is executed by a computer, cause the computer to carry out the method of Example 21 or 22.

Various operations may be described as multiple discrete actions or operations in turn, in a manner that is most helpful in understanding the claimed subject matter. However, the order of description should not be construed as to imply that these operations are necessarily order dependent. In particular, these operations may not be performed in the order of presentation. Operations described may be performed in a different order than the described embodiment. Various additional operations may be performed and/or described operations may be omitted in additional embodiments.

The terms "substantially," "close," "approximately," "near," and "about," generally refer to being within +/- 10% of a target value. Unless otherwise specified the use of the ordinal adjectives "first," "second," and "third," etc., to describe a common object, merely indicate that different instances of like objects are being referred to, and are not intended to imply that the objects so described must be in a given sequence, either temporally, spatially, in ranking or in any other manner.

For the purposes of the present disclosure, the phrases "A and/or B" and "A or B" mean (A), (B), or (A and B). For the purposes of the present disclosure, the phrase "A, B, and/or C" means (A), (B), (C), (A and B), (A and C), (B and C), or (A, B, and C).

The description may use the phrases "in an embodiment," or "in embodiments," which may each refer to one or more of the same or different embodiments. Furthermore, the terms "comprising," "including," "having," and the like, as used with respect to embodiments of the present disclosure, are synonymous.

As used herein, the term "circuitry" may refer to, be part of, or include an Application Specific Integrated Circuit (ASIC), an electronic circuit, a processor (shared, dedicated, or group), a combinational logic circuit, and/or other suitable hardware components that provide the described functionality. As used herein, "computer-implemented method" may refer to any method executed by one or more processors, a computer system having one or more processors, a mobile device such as a smartphone (which may include one or more processors), a tablet, a laptop computer, a set-top box, a gaming console, and so forth.

The terms "coupled," "communicatively coupled," along with derivatives thereof are used herein. The term "coupled" may mean two or more elements are in direct physical or electrical contact with one another, may mean that two or more elements indirectly contact each other but still cooperate or interact with each other, and/or may mean that one or more other elements are coupled or connected between the elements that are said to be coupled with each other. The term "directly coupled" may mean that two or more elements are in direct contact with one another. The term "communicatively coupled" may mean that two or more elements may be in contact with one another by a means of communication including through a wire or other interconnect connection, through a wireless communication channel or link, and/or the like.

Reference in the specification to "an embodiment," "one embodiment," "some embodiments," or "other embodiments" means that a particular feature, structure, or characteristic described in connection with the embodiments is included in at least some embodiments, but not necessarily all embodiments. The various appearances of "an embodiment," "one embodiment," or "some embodiments" are not necessarily all referring to the same embodiments. If the specification states a component, feature, structure, or characteristic "may," "might," or "could" be included, that particular component, feature, structure, or characteristic is not required to be included. If the specification or claim refers to "a" or "an" element, that does not mean there is only one of the elements. If the specification or claims refer to "an additional" element, that does not preclude there being more than one of the additional elements.

Furthermore, the particular features, structures, functions, or characteristics may be combined in any suitable manner in one or more embodiments. For example, a first embodiment may be combined with a second embodiment anywhere the particular features, structures, functions, or characteristics associated with the two embodiments are not mutually exclusive.

While the disclosure has been described in conjunction with specific embodiments thereof, many alternatives, modifications and variations of such embodiments will be apparent to those of ordinary skill in the art in light of the foregoing description. The embodiments of the disclosure are intended to embrace all such alternatives, modifications, and variations as to fall within the broad scope of the appended claims.

In addition, well-known power/ground connections to integrated circuit (IC) chips and other components may or may not be shown within the presented figures, for simplicity of illustration and discussion, and so as not to obscure the disclosure. Further, arrangements may be shown in block diagram form in order to avoid obscuring the disclosure, and also in view of the fact that specifics with respect to implementation of such block diagram arrangements are highly dependent upon the platform within which the present disclosure is to be implemented (i.e., such specifics should be well within purview of one skilled in the art). Where specific details (e.g., circuits) are set forth in order to describe example embodiments of the disclosure, it should be apparent to one skilled in the art that the disclosure can be practiced without, or with variation of, these specific details. The description is thus to be regarded as illustrative instead of limiting.

An abstract is provided that will allow the reader to ascertain the nature and gist of the technical disclosure. The abstract is submitted with the understanding that it will not be used to limit the scope or meaning of the claims. The following claims are hereby incorporated into the detailed description, with each claim standing on its own as a separate embodiment.

## Claims

1. An apparatus, comprising:
a package base layer;
a first die stacked on the package base layer; and
a voltage converter comprising a first inductor, an input node and an input path in the package base layer, and active circuitry in the first die, wherein the input path is to couple the input node to an input end of the first inductor without entering the first die, and the active circuitry is coupled to an output end of the first inductor.

2. The apparatus of claim 1, wherein a load of the voltage converter is in at least one of the first die or a second die stacked on the first die.

3. The apparatus of claim 1 or 2, wherein a load of the voltage converter is in a second die stacked on the first die, the first die comprises a gallium nitride substrate and the second die comprises a silicon substrate.

4. The apparatus of any one of claims 1-3, further comprising a set of current multipliers cascaded with, and downstream of, the active circuitry of the voltage converter, wherein the set of current multipliers is in at least one of the first die or a second die stacked on the first die.

5. The apparatus of claim 4, wherein the set of current multipliers comprises a plurality of switched-capacitor voltage down converters that are phase-interleaved.

6. The apparatus of any one of claims 1-5, further comprising a Continuously Scalable Conversion Ratio (CSCR) capacitive regulator cascaded with, and downstream of, the active circuitry of the voltage converter, wherein the CSCR capacitive regulator is in at least one of the first die or a second die stacked on the first die.

7. The apparatus of any one of claims 1-6, wherein:
the voltage converter comprises a second inductor, a ground node and a ground path in the package base layer;
the ground path is to couple the ground node to an output end of the second inductor without entering the first die; and
the active circuitry is coupled to an input end of the second inductor.

8. The apparatus of claim 7, wherein the voltage converter is to provide down conversion of a voltage at the input node by a ratio of at least 2:1, and an inductance of the first inductor is greater than an inductance of the second inductor.

9. The apparatus of claim 8, wherein the inductance of the first inductor is greater than the inductance of the second inductor by a ratio of at least 2:1.

10. The apparatus of any one of claims 7-9, wherein the active circuitry comprises:
a flying capacitor having a first side coupled to the output end of the first inductor and a second side coupled to the input end of the second inductor;
a first switch to couple the first side of the flying capacitor to an output node of the voltage converter; and
a second switch to couple the second side of the flying capacitor to a ground node.

11. The apparatus of claim 10, wherein the flying capacitor comprises an embedded package capacitor or a deep-trench capacitor.

12. The apparatus of any one of claims 1-11, further comprising at least one of an integrated circuit, a System on Chip, a System in Package or a computing device in which the package base layer, first die and voltage converter are provided, wherein the computing device comprises at least one of a processor circuitry, a memory circuitry, a storage circuitry, an acceleration circuitry, a communication circuitry, an input circuitry, an output circuitry, an interface circuitry or an external device.

13. The apparatus of any one of claims 1-12, wherein the voltage converter is a Kappa voltage converter.

14. A method, comprising:
receiving an input voltage at an input end of an inductor of a voltage regulator in a package base layer;
outputting an output voltage at an output end of the inductor in the package base layer;
coupling the output voltage to active circuitry of the voltage regulator in a first die stacked on the package base layer.

15. The method of claim 14, further comprising down converting the output voltage at the first die to provide an output voltage to a load.
